# EUROPEAN PATENT SPECIFICATION

(11) **EP 2 928 272 B1**
(45) Date of publication and mention of the grant of the patent: **21.09.2016**
(21) Application number: 15160245.5
(22) Date of filing: 23.03.2015
(51) Int. Cl.: H05K 1/05, H05K 3/00, H05K 1/02

(54) **A LIGHTING DEVICE AND CORRESPONDING METHOD**
BELEUCHTUNGSVORRICHTUNG UND ZUGEHÖRIGES VERFAHREN
DISPOSITIF D'ÉCLAIRAGE ET PROCÉDÉ CORRESPONDANT

(30) Priority: 27.03.2014 IT TO20140254
(43) Date of publication of application: 07.10.2015
(73) Proprietor: OSRAM GmbH, 80807 München (DE); OSRAM S.P.A. - SOCIETA' RIUNITE OSRAM EDISON CLERICI, 20126 Milano (IT)
(72) Inventor: Zanon, Franco, 36022 Cassola (Vicenza) (IT); Baldo, Lorenzo, 31040 Giavera del Montello (Treviso) (IT); Griffoni, Alessio, 30030 Fossò (Venezia) (IT)
(74) Representative: Bosotti, Luciano

(56) References cited:
- DE-A1-102007 046 075
- US-A1- 2009 225 544
- US-A1- 2011 316 035

## Description

### Technical field

The present invention relates to lighting devices.

One or more embodiments may refer to lighting modules employing LED sources as light radiation sources.

### Technological background

One of the significant features in lighting devices, such as for instance LED modules for outdoor use, is electric insulation (e.g. BreakDown Voltage V_{BD} > 2kV AC) for safety reasons.

Regulations such as IEC Standard 60598 envisage that each LED module must undergo a test at high voltage, named "high-pot", in order to check its robustness in terms of insulation.

The insulation features may depend on various factors, such as:
- the power supply voltage rating,
- the LED module working voltage,
- the kind of required insulation (e.g. basic insulation, supplementary insulation, double/reinforced insulation).

Lighting devices as LED modules may moreover satisfy the following requirements:
- high luminous flux (e.g. > 10.000 lm) ;
- high power efficiency (e.g. > 110 lm/W), which requires low thermal resistance Rₜₕ;
- high reliability in terms of high rated lumen maintenance life (e.g. > 60.000 hours) and low catastrophic failure rate (e.g. the soleder joints will survive at least 5.000 thermal cycles);
- low cost.

It is moreover desirable for the electric insulation level not to have a negative effect on other performance features.

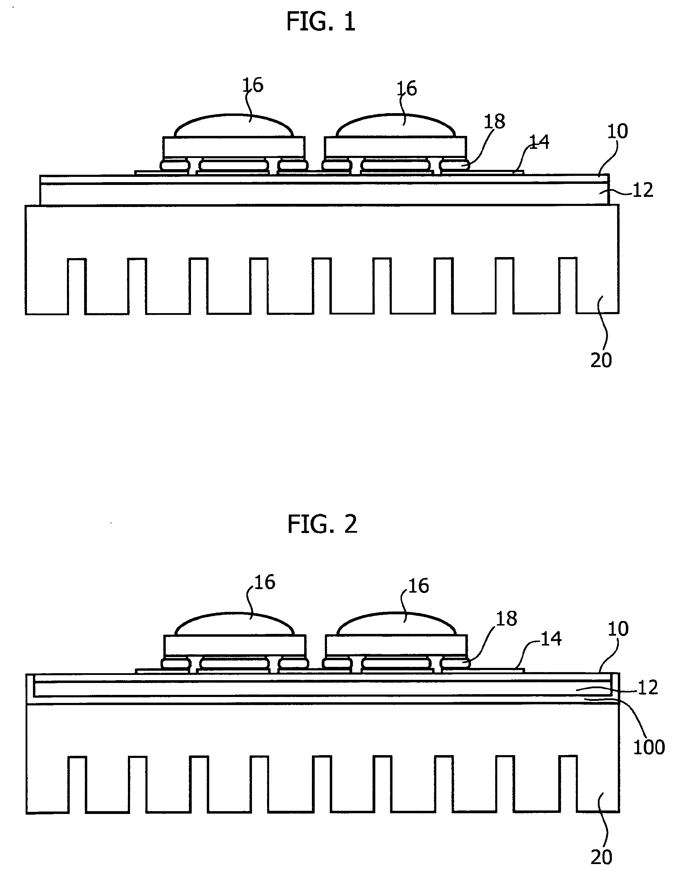

A solution to deal with this problem is schematically shown in Figure 1, wherein there is depicted, in an ideal cross-sectional view, the structure of a lighting device including an IMS (Insulated Metal Substrate) board comprising a thin layer of an electrically conductive material (e.g. copper) on a thin dielectric layer (e.g. thermally activated epoxy resin), laminated on a thick base metal (e.g. aluminium or copper).

Specifically, in the representation of Figure 1 references 10 and 12 respectively denote the dielectric layer and the base metal (e.g. aluminium or copper).

On the dielectric substrate 10 there are formed tracks or electrically conductive lines 14, on which one or more electrically powered light radiation sources 16 (e.g. LEDs) are mounted, e.g. via an SMT (Surface Mount Technology). The source(s) 16 are electrically connected to tracks or lines 14 via solder joints 18, e.g. with electrically conductive pastes or electrically conductive adhesives.

The assembly comprising the above-mentioned components, sometimes named Printed Board Assembly, PBA, is arranged on a carrier such as a housing or heat sink 20, adapted to spread to the outside the heat generated by the light radiation source(s) 16 during operation.

By resorting to a solution as exemplified in Figure 1, the features of electric insulation of the system are given mainly by dielectric layer 10.

In order to achieve high levels of BDV (BreakDown Voltage) it is possible to resort to different solutions.

For example, it is possible to increase the thickness of the dielectric material 10, without increasing the amount of material. This solution has however a negative impact on the thermal performance, because the thermal resistance Rₜₕ of dielectric layer 10 is proportional to its thickness, and the ability to transfer the heat generated by sources 16 towards the base metal 12 is consequently limited.

Another possibility consists in using more performing dielectrics. Dielectric materials with high breakdown voltage and high thermal conductivity are available as such (e.g. one may mention Aismalibar Cobritherm HTC 3,2 W 90µm, available from Aismalibar of Barcelona (Spain)). These materials, however, are rather costly.

Yet another possibility consists in inserting insulating foils between the PBA structure and the luminaire heatsink. This solution is reliable as regards an improvement of the electric insulation, but also in this case there is a negative effect as regards thermal resistance (Rₜₕ): insulating foils have low thermal conductivities with thicknesses in the range of 0,1-0,5 mm. Moreover, the insertion of insulating foils is an additional production step in the manufacturing process of the luminaire.

More specifically, the invention relates to a lighting device according to the preamble of claim 1, which is known, e.g. from US 2011/316035 A1. Documents DE 10 2007 046075 A1 and US 2009/225544 A1 are similarly of interest for the invention.

### Object and Summary

One or more embodiments aim at overcoming the previously outlined drawbacks.

In one or more embodiments, said object may be achieved thanks to a device having the features specifically set forth in claim 1 that follows.

One or more embodiments may also refer to a corresponding method according to claim 9.

The claims are an integral part of the technical teaching provided herein with reference to the invention.

One or more embodiments may advantageously offer one or more of the following advantages:
- an improvement of the electric insulation,
- a reduction of the thermal resistance of the system,
- an improved robustness to possible scratches of the PBA assembly,
- a simpler mounting of the lighting device,
- the possibility to use more than one insulating layer, which reduces the probability of faults.

### Brief description of the Figures

One or more embodiments will now be described, by way of non-limiting example only, with reference to the enclosed figures, wherein:
- Figure 1 has already been described in the foregoing, and
- Figures 2 to 4 show, according to modes similar to Figure 1, lighting devices according to embodiments.

It will be appreciated that, for clarity of illustration, the elements shown in the Figures 1 to 4 are not necessarily drawn to scale.

### Detailed Description

In the following description, numerous specific details are given to provide a thorough understanding of various exemplary embodiments. One or more embodiments may be practiced without one or several specific details, or with other methods, components, materials, etc. In other instances, well-known structures, materials, or operations are not shown or described in detail to avoid obscuring aspects of the embodiments. Reference throughout this specification to "an embodiment" means that a particular feature, structure, or characteristic described in connection with the embodiment is included in at least one embodiment. Thus, the possible appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The headings provided herein are for the reader's convenience only and do not interpret the scope or meaning of the embodiments.

Moreover, in Figures 2 to 4, parts and elements similar or equivalent to others already introduced in Figure 1 have been denoted with the same reference numbers. A corresponding description, therefore, will not be repeated for Figures 2 to 4. On the other hand, the use of the same reference number for parts or elements in the various Figures does not necessarily mean that they must be implemented in the same way in one or more embodiments as exemplified herein.

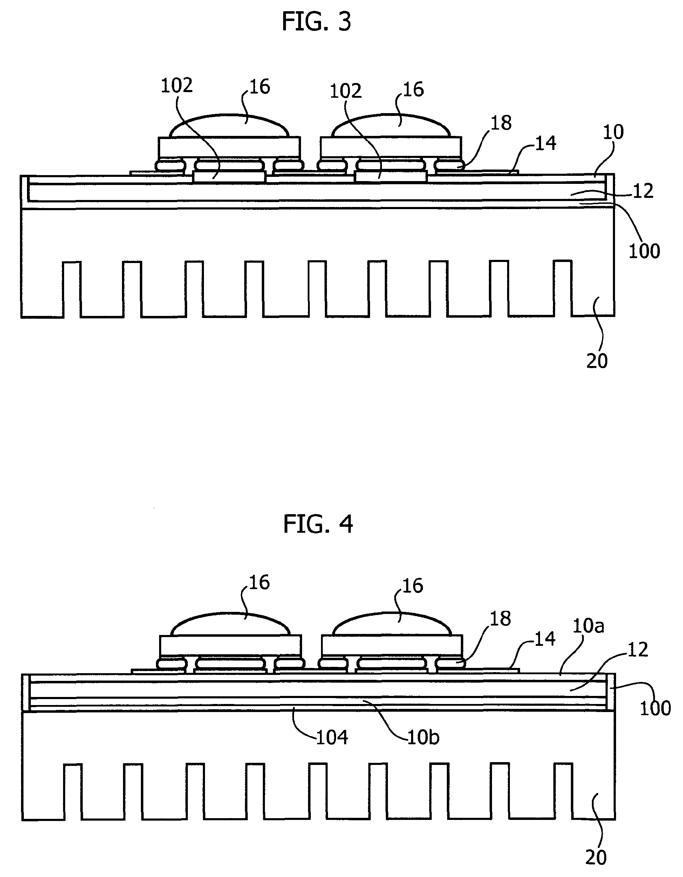

For the purposes of description it will be noticed that in Figures 2 to 4 there is shown, as an example, a lighting device including an insulated metal substrate (IMS) comprising elements 10, 12, 14 (Figures 2 and 3) or elements 10a, 12, 14 (Figure 4).

In the lighting device exemplified in Figures 2 to 4, the insulated metal substrate carries electrically conductive lines 14 (e.g. copper lines) and includes the metal base layer 12 (e.g. aluminium or copper), with one or more electrically powered light radiation sources 16 (e.g. LED sources).

In the lighting device exemplified in Figures 2 to 4, the thermally dissipative support (e.g. a housing or heatsink of a thermally conductive material, e.g. a metal as aluminium) carries the insulated metal substrate with the light radiation source(s) mounted on the electrically conductive lines 14 through solder joints 18 (e.g. electrically conductive pastes or electrically conductive adhesives).

In the lighting device exemplified in Figures 2 to 4 there is moreover provided a dielectric insulation, comprising a first electrically insulating layer interposed between the electrically conductive lines 14 and the base metal layer 12; this first insulating layer is denoted by reference 10 in Figures 2 and 3, and reference 10a in Figure 4.

In one or more embodiments, features that are shown here separately by referring either to Figures 2 and 3 or to Figure 4 may be present in combination (see for example Figure 4). In the same way, such features may be present in a reversed way to what is shown here, e.g. with features shown in Figures 2 and/or 3 being applied to embodiments corresponding to Figure 4, or with features shown in Figure 4 being applied to embodiments corresponding to Figures 2 and/or 3. In order to mention only one example among the various possibilities, we may refer to layer 104, which will be better detailed by referring to Figure 4.

In one or more embodiments, the first insulating layer may include, for example, at least one of:
- thermally-activated epoxy resin;
- glass-reinforced epoxy laminate sheet, such as for example FR4;
- epoxy-based insulation material with a thermally activating inorganic content filler, such as for example one or more of:
   - aluminium nitride (AlN)
   - alumina (Al₂O₃)
   - boron nitride (BN)
   - silicon nitride (Si₃N₄);
- a polyimide dielectric material with thermally conductive inorganic fillers;
- diamond-like carbon film, such as Thermeon™.

One or more embodiments may envisage the implementation of a lighting device such as an insulated LED module with low thermal resistance by providing, in addition to the first layer 10, 10a interposed between said electrically conductive lines 14 and said metal base layer 12, a second electrically insulating layer interposed between metal base layer 12 and thermally dissipative support 20.

In one or more embodiments, said second insulating layer may include a ceramic material coating 100 applied onto metal base layer 12.

In one or more embodiments, ceramic material coating 100 may extend (only) on the backside of the metal base layer 12, i.e. between metal base layer 12 and thermally dissipative support 20.

In one or more embodiments, as exemplified in Figures 2 and 3, the ceramic material coating 100 may extend both on the backside and on the lateral sides of the metal base layer 12 (and optionally of the first insulating layer 10). Figures 2 and 3 exemplify therefore one or more embodiments wherein such a ceramic coating 100 is applied to a PBA unit with an IMS-based insulation, by applying said ceramic coating 100 both on the back side (i.e. the side facing towards thermally dissipative support 20) of metal layer 12 and on the lateral sides thereof.

In one or more embodiments, as exemplified in Figure 4, the ceramic material coating 100 may extend (only) on the lateral sides of the metal base layer (and optionally of the first insulating layer 10).

In one or more embodiments, as exemplified in Figure 4, on the backside of metal base layer 12, i.e. between the metal base layer 12 and the thermally dissipative support 20, the second insulating layer 10b may include a dielectric material similar to the material of the first insulating layer 10a, the second insulating layer 10b being thicker than the first insulating layer 10a.

As exemplified in Figures 2 and 3, in one or more embodiments the second insulating layer 100 interposed between the metal base layer 12 and the thermally dissipative support 20 may be implemented as a ceramic-based coating applied on metal parts (e.g. aluminium), such as the back wall facing support 20 and/or the side walls of the PBA unit.

In one or more embodiments, such a ceramic material coating may be applied with different solutions on metal materials such as aluminium, of the type used in an IMS environment, e.g. wrought aluminium like 5052, 6082, 1050.

For example, in one or more embodiments, such a ceramic-based material may be a dense insulation layer of aluminium oxide crystallites.

In one or more embodiments, such a coating material may be obtained through a wet chemical process, e.g. as available from Cambridge Nanotherm of Haverhill (UK).

In one or more embodiments, the dielectric thicknesses may range from 10 to 50 µm (10 to 50. 10⁻⁶ m) .

In one or more embodiments, thermal conductivity may be up to 7 W/m.K.

Another possibility is the use of an alumina layer.

In one or more embodiment, such a coating material may be obtained via thermal spraying, wherein melted or heated materials are sprayed onto a surface to form a layer.

In one or more embodiments, thicknesses may range e.g. from 50 to 500 µm (50 to 500. 10⁻⁶ m) .

In one or more embodiments, thermal conductivity may be up to 22 W/m.K.

Such a ceramic-based coating (e.g. applied on aluminium) is moreover adapted to improve the resistance to scratches of the PBA backside, with the opportunity to provide in addition a higher thermal conductivity with respect to traditional insulating foils.

In one or more embodiments, in order to produce dielectric layer 10 ultrathin layers with high thermal conductivity may be adopted (e.g. materials such as Bergquist HPL 38µm, 3W/m.K, available from Bergquist Company of Chanhassen, MN 55317 USA, or Aismalibar Cobritherm HTC Ultra-thin 35µm, 3.2W/m.K, available from Aismalibar of Barcelona (Spain).

In one or more embodiments, in the presence of a reduced thickness of dielectric layer 10, the insulating properties are given mainly by ceramic coating 100.

In one or more embodiments it is therefore possible to improve heat transfer from light radiation sources 16 towards metal layer 12, layer 12 itself already acting as a heatsink, e.g. spreading the heat over its surface. The consequence is an improvement of the thermal conductivity towards the dissipative support 20.

In comparison with the application of insulating foils, the solution according to one or more presently exemplified embodiments may offer advantages such as:
- with approximately the same performance as for breakdown voltage (BDV), the thermal resistance Rth of ceramic coating 100 may be lower (up to 1 order of magnitude less) than in insulating foils,
- the production of the device is easier, because applying insulating foils may require additional manufacturing steps.

Figure 3 exemplifies one or more embodiments wherein there are provided one or more metal (e.g. copper) vias denoted by 102, which extend through dielectric layer 10.

A corresponding technological solution is available for example from SinkPAD LLC di Placentia CA 92870, USA.

The provision of such thermal vias from the light radiation sources 16 towards the metal layer 12 of the IMS structure leads to an improvement of performances from a thermal point of view (with the possibility of lowering the soldering temperature) while achieving on the whole an electric insulation level similar to what can be obtained in one or more embodiments as exemplified in Figure 2.

In one or more embodiments, as exemplified in Figures 2 and 3, ceramic coating 100 extends both on the bottom surface and on the lateral sides of the structure including metal material 12 (and dielectric layer 10).

One or more embodiments, as exemplified in Figure 4, may be seen as embodiments wherein the IMS dielectric layer denoted by 10 may so to say be split into two (sub)layers 10a and 10b.

In one or more embodiments, the first layer 10a (arranged in the same position as layer 10 of the former Figures, i.e. between metal layer 12 and light radiation sources 16 mounted on conductive lines 14) may be implemented as an ultra-thin layer with high thermal conductivity. (e.g. by using the previously-mentioned Bergquist and Aismalibar Cobritherm materials), so as to obtain a high thermal conductivity, without the need for that layer to perform an essential role in electric insulation.

In one or more embodiments, second layer 10b (interposed between metal layer 12 and heatsink 20) can play an important role in electric insulation, e.g. being adapted to be thicker than layer 10a while using the same amount of material. Therefore, Figure 4 exemplifies one or more embodiments adapted to be based on the principle of implementing the electric insulation mainly thanks to the second insulating layer, interposed between metal base layer 12 and thermally dissipative support 20.

In one or more embodiments, as exemplified in figure 4, a ceramic coating 100 (e.g. as previously exemplified with reference to Figures 2 and 3) may be present only on the sides of said structure including metal material 12 (and dielectric layer 10).

In one or more embodiments, as exemplified in Figure 4, the ceramic-based coating 100 on the sides of the PBA unit prevents lateral discharges from metal layer 12 towards heatsink 20.

In one or more embodiments the properties of thermal conductivity may be further enhanced thanks to a layer 104 of an electrically and thermally conductive material (e.g. copper) extending between layer 10b and heatsink 20, while keeping the general arrangement of the second electrically insulating layer 100; 10b interposed between the metal base material 12 and the thermally dissipative support (20).

Therefore, it will be appreciated that one or more embodiments:
- avoid a thickness increase of dielectric 10 or 10a interposed between conductive lines 14 and base metal 12, even enabling a decrease thereof, with the effect of reducing thermal resistance Rₜₕ and improving the ability to transfer heat from sources 16 towards base metal 12;
- do not require the use of high-performance dielectric materials;
- avoid the need of insulating foils between the PBA unit and the thermally dissipative support.

Of course, without prejudice to the underlying principles of the invention, the details and the embodiments may vary, even appreciably, with respect to what has been described herein by way of non-limiting example only, without departing from the extent of protection. Said extent is defined by the annexed claims.

## Claims

1. A lighting device, including:
- an insulated metal substrate (10, 12, 14; 10a, 12, 14) carrying electrically conductive lines (14), the insulated metal substrate including a metal base layer (12),
- at least one electrically powered light radiation source (16) mounted on the electrically conductive lines (14),
- a thermally dissipative support (20) carrying the insulated metal substrate (10, 12, 14; 10a, 12, 14) with said at least one electrically powered light radiation source (16) mounted on the electrically conductive lines (14),
- a first electrically insulating layer (10; 10a) interposed between said electrically conductive lines (14) and said base metal layer (12), and
- a second electrically insulating layer (100; 10b) interposed between said base metal layer (12) and said thermally dissipative support (20),
wherein said second electrically insulating layer (100) includes a ceramic material coating onto said base metal layer (12),
**characterized in that** said second insulating layer (10b) is thicker than said first insulating layer (10a).

2. The lighting device of claim 1, wherein said ceramic material coating extends between said base metal layer (12) and said thermally dissipative support (20) .

3. The lighting device of claim 1 or claim 2, wherein said ceramic material coating extends at the sides of said base metal layer (12) and, preferably, of said first electrically insulating layer (10; 10a).

4. The lighting device of any of the previous claims, wherein said ceramic material coating is selected out of:
- a layer of aluminium oxide crystallites, preferably with a thickness between 10 and 50 micron,
- an alumina layer, preferably with a thickness between 50 and 500 micron.

5. The lighting device of any of the previous claims, wherein said ceramic material coating is applied via one of a wet chemical process and thermal spraying.

6. The lighting device of any of the previous claims, wherein at least one (10; 10a) of said first (10; 10a) and said second (10b) electrically insulating layers includes at least one of:
- thermally-activated epoxy resin;
- glass-reinforced epoxy laminate sheet material;
- epoxy-based insulation material with thermally activating inorganic content filler, preferably selected as at least one of:
- aluminium nitride (AlN)
- alumina (Al₂O₃)
- boron nitride (BN)
- silicon nitride (Si₃N₄);
- polyimide dielectric with thermally conductive inorganic filler;
- diamond-like carbon film.

7. The lighting device of any of the previous claims, including thermally conductive vias (102) through said first insulating layer (10).

8. The lighting device of any of the previous claims, including a thermally conductive layer (104) between said second insulating layer (10b) and said thermally dissipative support (20).

9. A method of producing a lighting device, including:
- providing an insulated metal substrate (10, 12, 14; 10a, 12, 14) carrying electrically conductive lines (14), the insulated metal substrate including a metal base layer (12),
- mounting at least one electrically powered light radiation source (16) on the electrically conductive lines (14),
- providing a thermally dissipative support (20) carrying the insulated metal substrate (10, 12, 14; 10a, 12, 14) with said at least one electrically powered light radiation source (16) mounted on the electrically conductive lines (14),
- providing a first electrically insulating layer (10; 10a) interposed between said electrically conductive lines (14) and said base metal layer (12) and a second electrically insulating layer (100; 10b) interposed between said base metal layer (12) and said thermally dissipative support (20), and
- including in said second electrically insulating layer a ceramic material coating (100) onto said base metal layer (12), wherein said second insulating layer (10b) is thicker than said first insulating layer (10a).

## Patentansprüche

1. Beleuchtungsvorrichtung beinhaltend:
- ein isoliertes Metallsubstrat (10, 12, 14; 10a, 12, 14), das elektrisch leitende Leitungen (14) trägt, wobei das isolierte Metallsubstrat eine metallene Basisschicht (12) beinhaltet,
- zumindest eine elektrisch betriebene Lichtstrahlungsquelle (16), die an den elektrisch leitenden Leitungen (14) befestigt ist,
- einen wärmeableitenden Träger (20), der das isolierte Metallsubstrat (10, 12, 14; 10a, 12, 14) trägt, mit der zumindest einen elektrisch betriebenen Lichtstrahlungsquelle (16) befestigt auf den elektrisch leitenden Leitungen (14),
- eine erste elektrisch isolierende Schicht (10; 10a), die zwischen die elektrisch leitenden Leitungen (14) und die metallene Basisschicht (12) eingefügt ist, und
- eine zweite elektrisch isolierende Schicht (100; 10b), die zwischen die metallene Basisschicht (12) und den wärmeableitenden Träger (20) eingefügt ist,
wobei die zweite elektrisch isolierende Schicht (100) keramische Werkstoffbeschichtung auf der metallenen Basisschicht (12) beinhaltet,
**dadurch gekennzeichnet, dass** die zweite isolierende Schicht (10b) dicker als die erste isolierende Schicht (10a) ist.

2. Beleuchtungsvorrichtung nach Anspruch 1, wobei sich die keramische Werkstoffbeschichtung zwischen der metallenen Basisschicht (12) und dem wärmeableitenden Träger (20) erstreckt.

3. Beleuchtungsvorrichtung nach Anspruch 1 oder Anspruch 2, wobei sich die keramische Werkstoffbeschichtung an den Seiten der metallenen Basisschicht (12) und vorzugsweise der ersten elektrisch isolierenden Schicht (10; 10a) erstreckt.

4. Beleuchtungsvorrichtung nach einem der vorhergehenden Ansprüche, wobei die keramische Werkstoffbeschichtung ausgewählt ist aus:
- einer Schicht aus Aluminiumoxidkristalliten, vorzugsweise mit einer Dicke zwischen 10 und 50 Mikrometer,
- einer Aluminiumoxidschicht, vorzugsweise mit einer Dicke zwischen 50 und 500 Mikrometer.

5. Beleuchtungsvorrichtung nach einem der vorhergehenden Ansprüche, wobei die keramische Werkstoffbeschichtung über ein nasschemisches Verfahren oder thermisches Sprühen aufgebracht wird.

6. Beleuchtungsvorrichtung nach einem der vorhergehenden Ansprüche, wobei zumindest eine (10; 10a) der ersten (10; 10a) und der zweiten (10b) elektrisch isolierenden Schichten zumindest eines der Folgenden beinhaltet:
- thermisch aktiviertes Epoxidharz;
- glasverstärkter Epoxidverbundfolienwerkstoff;
- epoxidbasierter Isolationswerkstoff mit thermisch aktivierenden anorganischen Inhaltsfüllstoffen, vorzugsweise ausgewählt als zumindest einem von:
- Aluminiumnitrid (AlN)
- Aluminiumoxid (Al₂O₃)
- Bornitrid (BN)
- Silikonnitrid (Si₃N₄);
- Polyimiddielektrikum mit thermisch leitenden anorganischen Füllstoffen;
- diamantähnlicher Kohlenstofffilm.

7. Beleuchtungsvorrichtung nach einem der vorhergehenden Ansprüche, die thermisch leitenden Durchkontaktierungen (102) durch die erste isolierende Schicht (10) beinhaltet.

8. Beleuchtungsvorrichtung nach einem der vorhergehenden Ansprüche, die eine thermische leitende Schicht (104) zwischen der zweiten isolierenden Schicht (10b) und dem wärmeableitenden Träger (20) beinhaltet.

9. Verfahren zum Herstellen einer Beleuchtungsvorrichtung, beinhaltend:
- Bereitstellen eines isolierten Metallsubstrats (10, 12, 14; 10a, 12, 14), das elektrisch leitende Leitungen (14) trägt, wobei das isolierte Metallsubstrat eine metallene Basisschicht (12) beinhaltet,
- Befestigen zumindest einer elektrisch betriebenen Lichtstrahlungsquelle (16) auf den elektrisch leitenden Leitungen (14),
- Bereitstellen eines wärmeableitenden Trägers (20), der das isolierte Metallsubstrat (10, 12, 4; 10a, 12, 14) mit der zumindest einen elektrisch betriebenen Lichtstrahlungsquelle (16), welche auf den elektrisch leitenden Leitungen (14) befestigt ist, trägt,
- Bereitstellen einer ersten elektrisch isolierenden Schicht (10; 10a), die zwischen den elektrisch leitenden Leitungen (14) und der metallenen Basisschicht (12) eingefügt ist und einer zweiten elektrisch isolierenden Schicht (100; 10b), die zwischen der metallenen Basisschicht (12) und dem wärmeableitenden Träger (20) eingefügt ist, und
- Einschließen, in der zweiten elektrisch isolierenden Schicht, einer keramischen Werkstoffbeschichtung (100) auf der metallenen Basisschicht (12), wobei die zweite isolierende Schicht (10b) dicker als die erste isolierende Schicht (10a) ist.

## Revendications

1. Dispositif d'éclairage, incluant :
- un substrat métallique isolé (10, 12, 14 ; 10a, 12, 14) supportant des lignes électriquement conductrices (14), le substrat métallique isolé incluant une couche de base métallique (12),
- au moins une source de rayonnement de lumière électriquement alimentée (16) montée sur les lignes électriquement conductrices (14),
- un support thermiquement dissipatif (20) supportant le substrat métallique isolé (10, 12, 14 ; 10a, 12, 14) avec ladite au moins une source de rayonnement de lumière électriquement alimentée (16) montée sur les lignes électriquement conductrices (14),
- une première couche électriquement isolante (10 ; 10a) interposée entre lesdites lignes électriquement conductrices (14) et ladite couche métallique de base (12), et
- une seconde couche électriquement isolante (100 ; 10b) interposée entre ladite couche métallique de base (12) et ledit support thermiquement dissipatif (20),
dans lequel ladite seconde couche électriquement isolante (100) inclut un revêtement de matériau céramique sur ladite couche métallique de base (12),
**caractérisé en ce que** ladite seconde couche isolante (10b) est plus épaisse que ladite première couche isolante (10a) .

2. Dispositif d'éclairage selon la revendication 1, dans lequel ledit revêtement de matériau céramique s'étend entre ladite couche métallique de base (12) et ledit support thermiquement dissipatif (20).

3. Dispositif d'éclairage selon la revendication 1 ou la revendication 2, dans lequel ledit revêtement de matériau céramique s'étend au niveau des côtés de ladite couche métallique de base (12) et, de préférence de ladite première couche électriquement isolante (10 ; 10a).

4. Dispositif d'éclairage selon l'une quelconque des revendications précédentes, dans lequel ledit revêtement de matériau céramique est sélectionné parmi :
- une couche de cristallites d'oxyde d'aluminium, de préférence d'une épaisseur entre 10 et 50 micromètres,
- une couche d'alumine, de préférence d'une épaisseur entre 50 et 500 micromètres.

5. Dispositif d'éclairage selon l'une quelconque des revendications précédentes, dans lequel ledit revêtement de matériau céramique est appliqué par le biais d'une technique parmi un processus chimique par voie humide et une pulvérisation thermique.

6. Dispositif d'éclairage selon l'une quelconque des revendications précédentes, dans lequel au moins l'une (10 ; 10a) parmi ladite première (10 ; 10a) et ladite seconde (10b) couche électriquement isolante inclut au moins l'un parmi :
- une résine époxy thermiquement activée ;
- un matériau en feuille stratifiée d'époxy renforcé de verre ;
- un matériau d'isolation à base d'époxy avec un agent de remplissage à contenu inorganique thermiquement activant, de préférence sélectionné comme au moins l'un parmi :
- du nitrure d'aluminium (AIN)
- de l'alumine (Al₂O₃)
- du nitrure de bore (BN)
- du nitrure de silicium (Si₃N₄) ;
- un diélectrique polyimide avec un agent de remplissage inorganique thermiquement conducteur ;
- un film de carbone de type diamant.

7. Dispositif d'éclairage selon l'une quelconque des revendications précédentes, incluant des trous d'interconnexion thermiquement conducteurs (102) à travers ladite première couche isolante (10).

8. Dispositif d'éclairage selon l'une quelconque des revendications précédentes, incluant une couche thermiquement conductrice (104) entre ladite seconde couche isolante (10b) et ledit support thermiquement dissipatif (20).

9. Procédé de production d'un dispositif d'éclairage, incluant :
- la fourniture d'un substrat métallique isolé (10, 12, 14 ; 10a, 12, 14) supportant des lignes électriquement conductrices (14), le substrat métallique isolé incluant une couche de base métallique (12),
- le montage d'au moins une source de rayonnement de lumière électriquement alimentée (16) sur les lignes électriquement conductrices (14),
- la fourniture d'un support thermiquement dissipatif (20) supportant le substrat métallique isolé (10, 12, 14 ; 10a, 12, 14) avec ladite au moins une source de rayonnement de lumière électriquement alimentée (16) montée sur les lignes électriquement conductrices (14),
- la fourniture d'une première couche électriquement isolante (10 ; 10a) interposée entre lesdites lignes électriquement conductrices (14) et ladite couche métallique de base (12) et d'une seconde couche électriquement isolante (100 ; 10b) interposée entre ladite couche métallique de base (12) et ledit support thermiquement dissipatif (20), et
- le fait d'inclure, dans ladite seconde couche électriquement isolante, un revêtement de matériau céramique (100) sur ladite couche métallique de base (12), dans lequel ladite seconde couche isolante (10b) est plus épaisse que ladite première couche isolante (10a).
